# FASCICULE DE BREVET EUROPEEN

(11) **EP 0 606 181 B1**
(45) Date de publication et mention de la délivrance du brevet: **11.06.1997**
(21) Numéro de dépôt: 94400018.1
(22) Date de dépôt: 05.01.1994
(51) Int. Cl.: H01F 38/28, G01R 15/00

(54) **Transformateur, notamment transformateur de mesure, par exemple pour la détection de défauts sur les câbles électriques**
Transformator, insbesondere Messwandler, zum Beispiel zur Erkennung von Fehlern in elektrischen Kabeln
A transformer, in particular a measuring transformer e.g. for detecting faults in electric cables

(30) Priorité: 08.01.1993 FR 9300149
(43) Date de publication de la demande: 13.07.1994
(73) Titulaire: ETABLISSEMENTS BARDIN, F-92100 Boulogne-Billancourt (FR)
(72) Inventeur: Lefevre, Alain, F-77470 Fublaines (FR); Saintier, Jack, F-28630 Sours (FR)
(74) Mandataire: Casalonga, Axel

(56) Documents cités:
- EP-A- 0 497 681
- DE-C- 3 318 270
- US-A- 3 725 832
- US-A- 4 234 863
- US-A- 4 408 175

## Description

La présente invention se rapporte à un transformateur, notamment un transformateur de mesure tel que par exemple un transformateur pour la détection des défauts sur des câbles électriques, comprenant un circuit magnétique en forme de tore, et une bobine engagée sur ledit tore et constituant le secondaire du transformateur dont le primaire est constituée par un câble traversant le tore.

On connaît des transformateurs de ce type dits à tore fermé qui sont complètement enrobés d'une enveloppe rigide de résine. Leur principal inconvénient réside dans le fait qu'en vue de leur mise en place sur les câbles, ces derniers doivent être déconnectés pour que les transformateurs puissent être enfilés sur les câbles par une extrémité de ces derniers.

Pour remédier à cet inconvénient, il a également été proposé de diviser en deux les tores de tels transformateurs dits à tore divisé et d'enrober chaque moitié de tore dans une moitié d'enveloppe rigide en résine, les deux moitiés de transformateur étant assemblées par exemple à l'aide d'un collier de serrage. Le prix de revient de tels transformateurs est élevé.

Enfin, il est également connu de munir de tels transformateurs d'un circuit magnétique en forme de tore fendu élastique. Parmi ces tores fendus, un mode de réalisation particulièrement avantageux est décrit dans la demande de brevet français N° 2.672.152. Le tore suivant ce document est un tore cylindrique feuilleté fendu pouvant être ouvert par déformation élastique et être bloqué en position fermée, avec chevauchement de ses extrémités, par un élément d'assemblage à vis. La forme cylindrique de ce tore fendu permet une mise en place particulièrement simple et aisée du tore autour du câble.

Toutefois, ces transformateurs dits à tore fendu sont, à l'heure actuelle, utilisés sans enveloppe, c'est-à-dire sans protection du circuit magnétique et du secondaire enfilé sur ce circuit magnétique.

La présente invention vise un transformateur, notamment un transformateur de mesure tel qu'un transformateur de détection des défauts sur les câbles électriques, du type à tore magnétique fendu, transformateur dont aussi bien le circuit magnétique que le secondaire soient entourés et protégés par une enveloppe sans que cette enveloppe n'affecte la simplicité de mise en place de ce transformateur à tore fendu sur le câble.

L'invention a pour objet un transformateur, notamment un transformateur de mesure, par exemple un transformateur de détection de défauts sur des câbles, comprenant un circuit magnétique en forme de tore cylindrique feuilleté fendu pouvant être ouvert par déformation élastique et être bloqué en position fermée, avec chevauchement de ses extrémités, par un élément d'assemblage à vis. Le transformateur comprend, en outre, une bobine engagée sur le tore. Selon l'invention, le transformateur comprend, par ailleurs, un boîtier préfabriqué destiné à entourer le transformateur dans son ensemble, ce boîtier comprenant une première partie de boîtier rigide présentant côte à côte un logement pour recevoir la bobine constituant le secondaire du transformateur et un logement pour recevoir l'élément d'assemblage du tore fendu, la bobine et l'élément d'assemblage étant engagés sur une première extrémité du tore. Ce boîtier, comprend, en outre, une seconde partie de boîtier déformable en forme de segment de couronne annulaire destinée à entourer la partie restante du tore, une première extrémité de cette partie de boîtier déformable étant reliée ou pouvant être reliée à la partie de boîtier rigide, côté logement de la bobine, et la seconde extrémité de la partie de boîtier déformable étant munie de moyens pour son blocage sur la partie de boîtier rigide, côté logement de l'élément d'assemblage. L'élément d'assemblage du tore comporte une butée pour définir la position de la première extrémité du tore et la partie de boîtier déformable présente une longueur telle que sa seconde extrémité ne puisse être bloquée sur la partie de boîtier rigide que lorsque la seconde extrémité du tore est engagée dans l'élément d'assemblage à la profondeur requise pour se trouver en position de chevauchement, donc en position d'assemblage, avec la première extrémité du tore.

De préférence, l'élément d'assemblage comporte des moyens de guidage dépassant de la partie de boîtier rigide, pour guider la seconde extrémité du tore lors de l'engagement de cette dernière dans l'élément d'assemblage disposé dans son logement dans la partie de boîtier rigide.

Pour que la partie de boîtier déformable réalisée avantageusement d'une seule pièce avec la partie de boîtier rigide soit facilement déformable en vue de la mise en place du transformateur sur le câble par ouverture du tore, elle présente avantageusement une structure ondulée sur une partie au moins de sa longueur.

De préférence, la partie de boîtier déformable comprend, dans le sens de sa longueur, une alternance de segments rigides et de segments ondulés, les segments ondulés ayant de préférence une épaisseur de paroi plus faible que les segments rigides.

Suivant un mode de réalisation préféré, la partie de boîtier rigide comprend un fond entourant sur trois côtés la bobine et l'élément d'assemblage qui peuvent ainsi être introduits dans le fond par le quatrième côté ouvert, et un couvercle susceptible d'obturer le quatrième côté.

De façon analogue, la partie de boîtier déformable est avantageusement formée d'un fond entourant le tore sur trois côtés (une tranche et les deux faces larges opposée) et un couvercle entourant le tore sur l'autre tranche. n est ainsi possible, après avoir engagé la bobine et l'élément d'assemblage sur le tore, d'introduire facilement l'ensemble dans le fond des deux parties de boîtier et de l'enveloppe, le tore occupant alors automatiquement sa position correcte en vue de son ouverture par déformation élastique, pour la mise en place du transformateur sur le câble, et en vue de sa fermeture à l'aide de l'élément d'assemblage.

De préférence, le couvercle peut être réalisé d'une seule pièce par moulage avec le fond de la partie de boîtier rigide, en étant articulé sur le fond par une charnière venue du moulage.

Des moyens d'encliquetage sont alors avantageusement prévus sur le fond et le couvercle de la partie de boîtier rigide pour maintenir le couvercle en position fermée.

Sur la partie de boîtier déformable, le couvercle est avantageusement un couvercle rapporté, le fond et le couvercle comportant également des moyens d'encliquetage pour maintenir le couvercle en position fermée sur le fond.

De préférence, les moyens de blocage de la seconde extrémité de la partie de boîtier déformable sur la partie de boîtier rigide sont prévus sur le couvercle de la partie de boîtier déformable et sur les moyens de guidage prévus sur l'élément d'assemblage.

Il est également avantageux que le couvercle de la partie de boîtier rigide soit subdivisé en une première partie de couvercle recouvrant le logement pour la bobine et articulée par ladite charnière sur le fond, et en une seconde partie de couvercle reliée par une charnière à la première partie de couvercle et recouvrant le logement pour l'élément d'assemblage.

Afin d'assurer d'une manière simple un positionnement et un centrage corrects du tore par rapport au câble qu'il est destiné à entourer, la partie de boîtier rigide comporte des moyens réalisés de préférence d'une seule pièce avec le fond de cette partie, pour assurer l'appui du transformateur sur le câble. Ces moyens comprennent avantageusement une surface d'appui, par exemple en segment de cylindre, et au moins une ligature, par exemple un lien élastique, pour solidariser cette surface d'appui avec le câble.

En se référant aux dessins schématiques annexés, on va décrire ci-après plus en détail un mode de réalisation illustratif et non limitatif d'un transformateur conforme à l'invention; sur les dessins :
la figure 1 est une vue latérale, suivant la flèche I de la figure 2, d'un transformateur conforme à l'invention disposé autour d'un câble électrique;
la figure 2 est une vue en bout, suivant la flèche II de la figure 1, de ce même transformateur;
la figure 3 représente le transformateur de la figure 2, son boîtier étant ouvert.

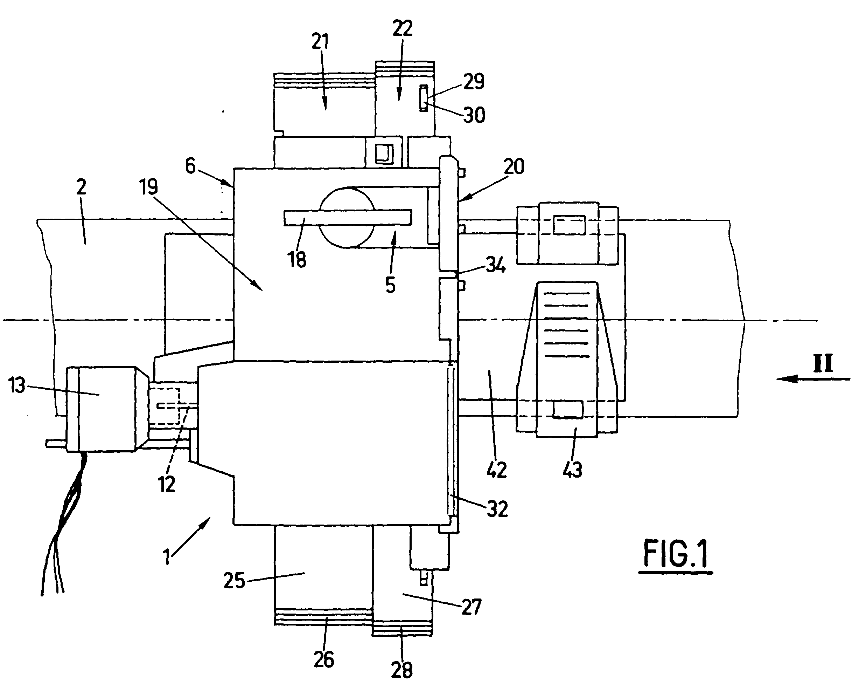

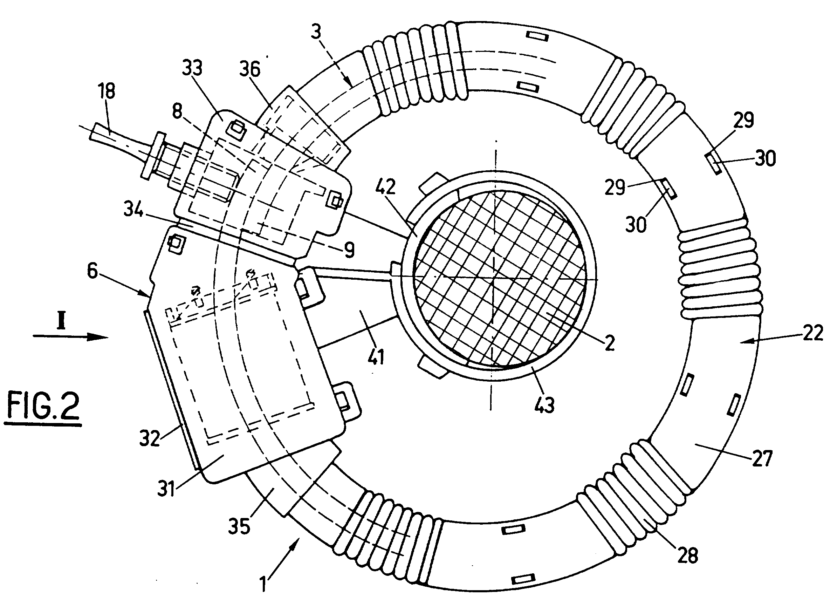

Selon les figures 1 et 2, un transformateur 1, à savoir un transformateur de mesure, est associé à un câble 2 pour détecter les défauts du courant passant dans ledit câble.

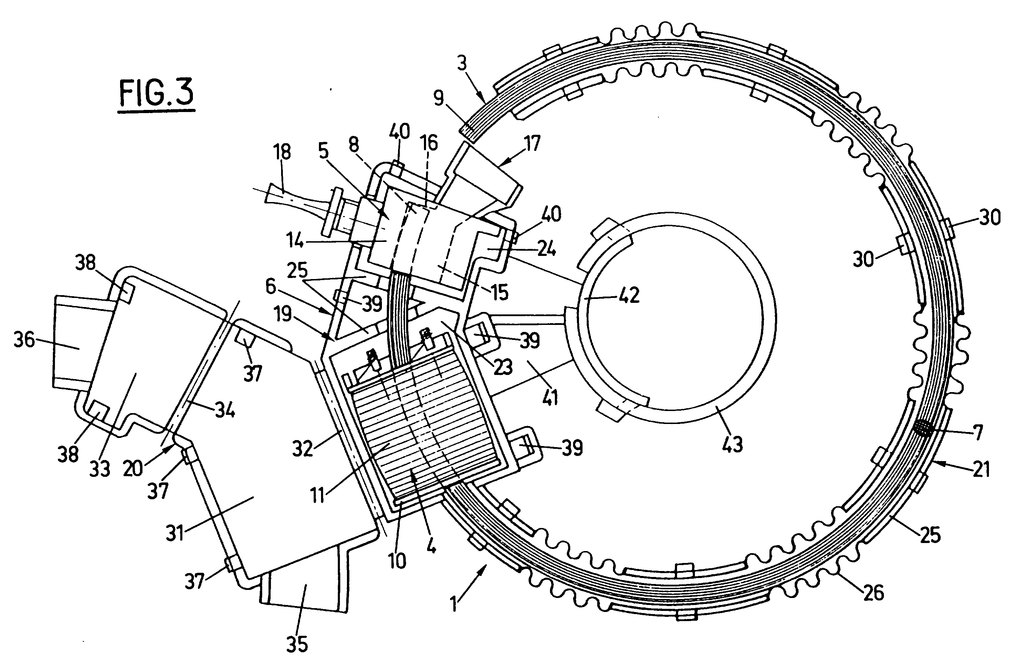

Comme le montre surtout la figure 3, le transformateur 1 dont le câble 2 constitue le primaire comprend principalement un circuit magnétique 3, une bobine 4 servant de secondaire, un élément d'assemblage 5 pour le circuit magnétique 3, et un boîtier 6 entourant l'ensemble du transformateur.

Le circuit magnétique 3 est constitué par un tore cylindrique feuilleté déformable selon la demande de brevet français N° 2.672.152. Ce tore fendu est formé d'une pluralité de tronçons de ruban de tôle, concentriques en forme de cylindre fendu, maintenus en position par deux soudures 7 réalisées sur les deux tranches opposées du tore, dans une position diamétralement opposée aux extrémité 8 et 9 du tore 3.

La bobine 4 comprend une carcasse de bobine 10 pouvant être traversée par le tore 3, cette carcasse portant un bobinage 11 ainsi que des bornes 12 avec lesquelles peut coopérer un connecteur 13 visible sur la figure 1.

L'élément d'assemblage 5 est constitué par un corps 14 de forme générale parallélépipédique, traversée par un évidement rectangulaire 15 ayant une largeur légèrement supérieure à la largeur du tore 3 et une hauteur légèrement supérieure au double de l'épaisseur du tore 3, sauf à l'un des débouchés de l'évidement 15 où la hauteur de l'évidement 15 est réduite sensiblement de moitié de l'extérieur, par une butée 16 prévue à cet endroit. Sur ce même côté du corps 14, l'évidement 15 de hauteur réduite est prolongé vers l'extérieur du corps 14 proprement dit par des moyens de guidage 17 dont la fonction apparaîtra par la suite.

Le corps 14 comporte par ailleurs, dans sa paroi extérieure, un trou taraudé dans lequel est engagée une vis de blocage 18 susceptible d'être manoeuvrée à la main de l'extérieur du transformateur.

Le boîtier 6 moulé en matière plastique comprend (voir surtout figure 1) une partie rigide composée d'un fond 19 et d'un couvercle 20, ainsi qu'une partie déformable également formée d'un fond 21 et d'un couvercle 22.

Le fond 19 de la partie rigide renferme un logement 23 pour la bobine 4 et un logement 24 pour l'élément d'assemblage 5, ces deux logements 23, 24 disposés côte à côte étant séparés l'un de l'autre par des cloisons 25 de manière que la bobine 4, d'une part, et l'élément d'assemblage 5, d'autre part, soient maintenus positionnés dans les logements 23 et 24 dans lesquels ils peuvent être engagés par coulissement depuis le côté ouvert du fond 19 de la partie rigide.

Il est à noter que, comme celà apparaît sur la figure 3, le fond 19 comporte par ailleurs, dans les cloisons 25 ainsi que dans les parois d'extrémité opposées, des échancrures disposées de manière à permettre l'engagement simultané dans le fond 19, non seulement de la bobine 4 et de l'élément d'assemblage 5, mais également de la partie du tore 3 proche de l'extrémité 8 de ce dernier, partie sur laquelle sont préalablement engagées la bobine 4 et l'élément d'assemblage 5.

Le fond 21 de la partie déformable du boîtier est réalisé d'une seule pièce avec le fond 19 de la partie rigide et se raccorde au fond 19 du côté du logement 23 pour la bobine 4. Le fond 21 présente la forme d'un segment de couronne circulaire dans lequel le tore 3 peut être emboîté par l'une de ses tranches de manière que le fond 21 entoure le tore 3 correctement sur cette tranche et sur ses deux faces opposées. La longueur du fond 21 de la partie de boîtier déformable est choisie de manière que lorsque le tore 3 est correctement engagé dans le fond 19 de la partie de boîtier rigide, sa première extrémité 8 étant en appui contre la butée 16 de l'élément d'assemblage 5, la seconde extrémité 9 du tore 3 dépasse quelque peu de l'extrémité libre du fond 21 de la partie de boîtier déformable.

Il est à noter que le fond 21 est formé, dans le sens de la longueur, d'une alternance de segments 25 rigides, plus épais, et de segments 26 ondulés, plus minces, ces derniers procurant au fond 21 une certaine aptitude à se déformer élastiquement.

Le couvercle 22 qui est destiné à recouvrir l'autre tranche du tore 3, présente également une structure formée d'une alternance de segments rigides 27 et de segments ondulés 28. Le couvercle 22 comporte des moyens d'encliquetage 29 coopérant, lorsque le couvercle 22 est rapporté sur le fond 21, avec des moyens d'encliquetage 30 prévu sur le fond, pour retenir le couvercle sur le fond.

Le couvercle 20 de la partie de boîtier rigide comprend une partie de couvercle 31 articulée par une charnière 32 sur la partie du fond 19 entourant le logement 23 pour la bobine 4, et une partie de couvercle 33 reliée à la partie de couvercle 31 par une charnière 34 de telle manière que lorsque la partie de couvercle 31 est fermée sur le fond 19, la partie de couvercle 33 puisse encore être ouverte. La partie de couvercle 31 comporte d'un côté un prolongement 35 et la partie de couvercle 33 comporte sur le côté opposé un prolongement 36, ces deux prolongements 35, 36 étant conformés de manière à pouvoir recouvrir, lors de la fermeture des deux parties de couvercle 31 et 33, les deux extrémités du couvercle 22 rapporté sur le fond 21 de la partie de boîtier déformable.

Les deux parties de couvercles 31 et 33 présentent en outre des moyens d'encliquetage 37 et 38 coopérant avec des moyens d'encliquetage 39 et 40 du fond 19 en vue du blocage du couvercle 20 en position fermée.

Des moyens d'encliquetage non représentés peuvent également être prévus, à l'extrémité libre de la partie de boîtier déformable, soit sur le fond 21 soit sur le couvercle 22, pour coopérer avec des moyens d'encliquetage non représentés prévus sur les moyens de guidage 17 du corps 14 de l'élément d'assemblage 5 lorsque, selon la figure 2, la seconde extrémité 9 du tore 3 est engagée à fond, c'est-à-dire en position d'assemblage, dans le fond 19, en butée contre la cloison 25, bloquant ainsi la partie de boîtier déformable dans cette position sur la partie de boîtier rigide.

Enfin, le fond 19 comporte intérieurement une patte de support 41 portant à son extrémité intérieure libre une surface d'appui 42 en forme de segment de cylindre dont la courbure est adaptée à la courbure du câble 2. Une ligature 43 constituée, dans l'exemple représenté, par un lien élastique permet de rendre la surface d'appui 42 solidaire du câble, en vue du maintien en position du transformateur sur le câble.

On va décrire ci-après le montage et le mode d'utilisation du transformateur conforme à l'invention.

Après avoir fabriqué un tore de transformateur 3 suivant le procédé révélé par la demande de brevet français N° 2. 672.152, on engage sur la première extrémité 8 de ce tore une bobine 4 et un élément d'assemblage 5, en veillant à ce que cette extrémité 8 du tore 3 se trouve en appui contre la butée 16. Dans cette position, on engage le tore 3 avec la bobine 4 et l'élément d'assemblage 5 dans le fond 19, 21 du boîtier 6, dans la position illustrée par la figure 3. On applique ensuite et bloque le couvercle 22 sur le fond 21 de la partie de boîtier déformable, les moyens d'encliquetage 29, 30 empêchant toute séparation intempestive du couvercle 22 lors de la déformation ultérieure de la partie de boîtier déformation, et on ferme les parties de couvercle 31 et 33 sur le fond 19 de la partie de boîtier rigide.

Le transformateur est ainsi prémonté, prêt à être mis en oeuvre sur un câble.

En vue de la mise en oeuvre du transformateur sur un câble 2, la ligature 43 est détachée et le tore 3, à l'endroit de sa partie de boîtier déformable 21, 22, est ouvert par déformation élastique, d'une valeur suffisante pour pouvoir être engagé sur le câble 2. Après positionnement de la surface d'appui 42 sur le câble 2, la ligature 43 est refermée autour du câble 2, de sorte que le transformateur se trouve correctement positionné sur le câble 2.

Pour fermer le tore 3, on déforme le tore 3 légèrement vers l'intérieur à partir de la position selon la figure 3 pour pouvoir engager sa seconde extrémité 9 dans les moyens de guidage 17. En poussant ensuite les deux extrémités du tore 3 l'une vers l'autre, on enfonce la seconde extrémité 9 dans l'évidement 15 de l'élément d'assemblage 5, radialement à l'intérieur de la première extrémité 8 en appui contre la butée 16, jusqu'à l'entrée en contact de l'extrémité 9 avec la cloison 25. Les deux extrémités 8 et 9 du tore 3 se trouvant alors en position de chevauchement, on serre la vis 18, ce qui bloque les deux extrémités 8 et 9 du tore 3 en position de chevauchement dans l'élément d'assemblage 5.

Le mode de réalisation représenté et décrit n'a été donné qu'à titre indicatif et de nombreuses modifications et variantes sont possible dans le cadre de l'invention.

Il en est ainsi notamment en ce qui concerne les moyens prévus sur la partie de boîtier déformable pour rendre cette dernière déformable, la réalisation du couvercle 20 de la partie de boîtier rigide et sa subdivision en deux parties 31, 33, les moyens de blocage du couvercle 22 sur le fond 21 de la partie de boîtier déformable et du couvercle 20 sur le fond 19 de la partie de boîtier rigide.

Un avantage particulier du transformateur tel que représenté et décrit consiste dans la possibilité de sa mise en place "à l'aveugle" sur un câble, grâce à l'appui de la première extrémité 8 du tore 3 contre une butée 16 de l'élément d'assemblage 5 et aux moyens de guidage 17 prévus sur l'élément d'assemblage S pour amener la seconde extrémité 9 du tore 3 automatiquement à la position correcte dans l'élément d'assemblage 5 (position de chevauchement avec la première extrémité 8). Cette introduction de la seconde extrémité 9 du tore 3 dans l'élément d'assemblage est d'ailleurs facilitée par le fait que l'élément d'assemblage 5 présente du jeu, donc une certaine mobilité, dans son logement 24, comme cela apparaît sur la figure 3.

Par ailleurs, le fond 21 de la partie de boîtier déformable, au lieu d'être réalisée d'une seule pièce avec le fond 19 de la partie de boîtier rigide, pourrait également être séparé et être alors relié au fond 19, par exemple par des moyens d'encliquetage ou analogues.

## Revendications

1. Transformateur, notamment transformateur de mesure tel que transformateur pour la détection des défauts sur des câbles électriques, comprenant un circuit magnétique en forme de tore (3) cylindrique feuilleté fendu pouvant être ouvert par déformation élastique et être bloqué en position fermée, avec chevauchement de ses extrémités (8, 9), par un élément d'assemblage à vis (5), et une bobine (4) servant de secondaire, engagée sur ledit tore, caractérisé par le fait qu'il comprend, en outre, un boîtier (6) préfabriqué destiné à entourer le transformateur (1) dans son ensemble, ce boîtier comprenant une première partie de boîtier rigide (19, 20) présentant côte à côte un logement (23) pour recevoir la bobine (4) et un logement (24) pour recevoir l'élément d'assemblage (5), la bobine et l'élément d'assemblage étant engagés sur une première extrémité (8) du tore (3), et une seconde partie de boîtier déformable (21, 22) en forme de segment de couronne annulaire, destinée à entourer la partie restante du tore, une première extrémité de cette partie de boîtier déformable étant reliée ou pouvant être reliée à la partie de boîtier rigide, côté logement de la bobine, et la seconde extrémité de la partie de boîtier déformable étant munie de moyens pour son blocage sur la partie de boîtier rigide, côté logement de l'élément d'assemblage, que l'élément d'assemblage (15) du tore comporte une butée (16) pour définir la position de la première extrémité (8) du tore et que la partie de boîtier déformable présente une longueur telle que sa seconde extrémité ne puisse être bloquée sur la partie de boîtier rigide que lorsque la seconde extrémité (9) du tore est engagée dans l'élément d'assemblage (5) à la profondeur requise pour se trouver en position de chevauchement, donc en position d'assemblage, avec la première extrémité (8) du tore.

2. Transformateur suivant la revendication 1, caractérisé par le fait que l'élément d'assemblage (5) comporte des moyens de guidage (17) dépassant la partie de boîtier rigide (19, 20) pour guider la seconde extrémité (9) du tore lors de l'engagement de cette dernière dans l'élément d'assemblage disposé dans son logement (4) dans la partie de boîtier rigide.

3. Transformateur suivant l'une quelconque des revendications précédentes, caractérisé par le fait que la partie de boîtier déformable (21, 22) est constituée d'une seule pièce avec la partie de boîtier rigide (19, 20).

4. Transformateur suivant l'une quelconque des revendications précédentes, caractérisé par le fait que la partie de boîtier déformable (21,22) présente une structure ondulée (26, 28) sur une partie au moins de sa longueur.

5. Transformateur suivant la revendication 4, caractérisé par le fait que la partie de boîtier déformable comprend, dans le sens de sa longueur, une alternance de segments rigides (25, 27) et de segments ondulés (26, 28), les segments ondulés ayant de préférence une épaisseur de paroi plus faible que les segments rigides.

6. Transformateur suivant l'une quelconque des revendications précédentes, caractérisé par le fait que la partie de boîtier rigide comprend un fond (19) entourant sur trois côtés la bobine (4) et l'élément d'assemblage (5) introduits dans le fond par le quatrième côté ouvert, un couvercle (20) susceptible d'obturer le quatrième côté.

7. Transformateur suivant la revendication 6, caractérisé par le fait que le couvercle (20) est réalisé d'une seule pièce par moulage avec le fond (19) de la partie de boîtier rigide, en étant articulé sur le fond par une charnière (32) venue de moulage.

8. Transformateur suivant l'une quelconque des revendications précédentes, caractérisé par le fait que la partie de boîtier déformable comprend un fond (21) entourant le tore (3) sur trois côtés (une tranche et les deux faces larges opposées) et un couvercle (22) entourant le tore sur l'autre tranche.

9. Transformateur suivant l'une quelconque de revendications 6 à 8, caractérisé par le fait que le fond (19, 21) et le couvercle (20, 22) comportent des moyens d'encliquetage (29, 30, 37, 38, 39, 40) pour maintenir le couvercle en position fermée sur le fond.

10. Transformateur suivant l'une quelconque des revendications précédentes, caractérisé par le fait que la partie de boîtier rigide comporte des moyens réalisés de préférence d'une seule pièce avec le fond (19) de cette partie, pour assurer l'appui du transformateur sur la câble, par exemple sur une surface d'appui (42) en segment de cylindre et au moins une ligature (43), par exemple un lien élastique.

## Patentansprüche

1. Transformator, insbesondere Meßwandler nach Art eines Transformators zur Erkennung von Fehlern in elektrischen Kabeln, mit einem Magnetkreis in Form eines laminierten und geschlitzten, zylindrischen Rings (3), welcher durch elastische Deformation offen und in geschlossener Position mit Überlappung seiner Enden (8, 9) durch ein Schraub-Verbindungselement (5) verriegelt werden kann, und mit einer als Sekundärwicklung dienenden, auf dem genannten Ring angeordneten Spule (4), dadurch gekennzeichnet, daß er zusätzlich ein vorgefertigtes Gehäuse (6) aufweist, das dazu bestimmt ist, den Transformator (1) in seiner Gesamtheit zu umschließen, wobei dieses Gehäuse einen ersten, starren Gehäuseteil (19, 20), welcher nebeneinander eine Aufnahme (23) zur Unterbringung der Spule und eine Aufnahme (24) zur Unterbringung des Verbindungselementes (5), wobei die Spule und das Verbindungselement mit einem ersten Ende (8) des Rings (3) verbunden sind, und einen zweiten, deformierbaren Gehäuseteil (21, 22) in Form eines Ringkranzsegmentes aufweist, der dazu bestimmt ist, den restlichen Teil des Rings zu umschließen, wobei ein erstes Ende dieses deformierbaren Gehäuseteils mit dem starren Gehäuseteil neben der Aufnahme für die Spule verbunden oder verbindbar ist und wobei das zweite Ende des deformierbaren Gehäuseteiles mit Mitteln zu seiner Verriegelung an dem starren Gehäuseteil neben der Aufnahme für das Verbindungselement versehen ist, daß das Verbindungselement (15) des Rings einen Anschlag (16) zur Festlegung der Position des ersten Endes (8) des Rings umfaßt und daß der deformierbare Gehäuseteil eine derartige Länge aufweist, daß sein zweites Ende nur dann an dem starren Gehäuseteil verriegelt werden kann, wenn das zweite Ende (9) des Rings in dem Verbindungselement (5) in derjenigen Tiefe liegt, welche erforderlich ist, damit es sich in Überlappungsstellung, also in Verbindungsposition, mit dem ersten Ende (8) des Rings befindet.

2. Transformator nach Anspruch 1, dadurch gekennzeichnet, daß das Verbindungselement (5) Führungsmittel (17) umfaßt, welche von dem starren Gehäuseteil (19, 20) vorstehen, um das zweite Ende (9) des Rings bei der Einfügung des letzteren in das in seiner Aufnahme (4) in dem starren Gehäuseteil angeordnete Verbindungselement zu führen.

3. Transformator nach einem der vorangehenden Ansprüche, dadurch gekennzeichnet, daß der deformierbare Gehäuseteil (21, 22) einstückig mit dem starren Gehäuseteil (19, 20) ausgebildet ist.

4. Transformator nach einem der vorangehenden Ansprüche, dadurch gekennzeichnet, daß der deformierbare Gehäuseteil (21, 22) zumindest auf einem Teil seiner Länge eine Wellenstruktur (26, 28) aufweist.

5. Transformator nach Anspruch 4, dadurch gekennzeichnet, daß der deformierbare Gehäuseteil in seiner Längsrichtung abwechselnd starre Segmente (25, 27) und gewellte Segmente (26, 28) umfaßt, wobei die gewellten Segmente vorzugsweise eine geringere Wandstärke als die starren Segmente besitzen.

6. Transformator nach einem der vorangehenden Ansprüche, dadurch gekennzeichnet, daß der starre Gehäuseteil einen Boden (19) umfaßt, der die Spule (4) und das Verbindungselement (5) auf drei Seiten umschließt, welche durch die offene vierte Seite in den Boden eingeführt wurden, wobei ein Deckel (20) in der Lage ist, die vierte Seite abzudecken.

7. Transformator nach Anspruch 6, dadurch gekennzeichnet, daß der Deckel (20) durch Formgießen einstückig mit dem Boden (19) des starren Gehäuseteils ausgebildet ist, wobei er an dem Boden mittels eines durch das Formgießen angeformten Scharniers (32) angelenkt ist.

8. Transformator nach einem der vorangehenden Ansprüche, dadurch gekennzeichnet, daß der deformierbare Gehäuseteil einen Boden (21), der den Ring (13) auf drei Seiten (einer Scheibenoberfläche und den beiden einander gegenüberliegenden breiten Umfangsseiten) umschließt, und einen Deckel (22), der den Ring auf der anderen Scheibenoberfläche umschließt, aufweist.

9. Transformator nach einem der Ansprüche 6 bis 8, dadurch gekennzeichnet, daß der Boden (19, 21) und der Deckel (20, 22) Verschlußeinrichtungen (29, 30, 37, 38, 39, 40) umfassen, um den Deckel in Schließstellung auf dem Boden zu halten.

10. Transformator nach einem der vorangehenden Ansprüche, dadurch gekennzeichnet, daß der starre Gehäuseteil vorzugsweise einstückig mit dem Boden (19) dieses Teiles ausgebildete Mittel aufweist, um die Anlage des Transformators an dem Kabel zu gewährleisten, beispielsweise über eine Anlagefläche (42) in Form eines Zylindersegmentes und mindestens ein Wickelelement (43), beispielsweise einen elastischen Bund.

## Claims

1. Transformer, especially a measurement transformer such as a transformer for detecting faults on electrical cables, comprising a split laminated cylindrical toroidal magnetic circuit (3) which can be opened by elastic deformation and locked in the closed position with its ends (8, 9) overlapping by a screw-type assembly member (5) and a coil (4) constituting its secondary fitted to said toroidal magnetic circuit, characterised in that it further comprises a prefabricated casing (6) adapted to enclose the transformer (1) entirely and comprising a rigid first casing part (19, 20) having side by side a housing (23) for receiving the coil (4) and a housing (24) for receiving the assembly member (5), the coil and the assembly member being fitted to a first end (8) of the toroidal magnetic circuit (3), and a deformable second casing part (21, 22) of annular ring segment shape adapted to enclose the remaining part of the toroidal magnetic circuit, a first end of this deformable casing part being joined or joinable to the rigid casing part, at the same end as the coil housing, and the second end of the deformable casing part being provided with means for locking it to the rigid casing part at the same end as the assembly member housing, in that the toroidal magnetic circuit assembly member (15) includes an abutment (16) for defining the position of the first end (8) of the toroidal magnetic circuit and in that the deformable casing part has a length such that its second end cannot be locked to the rigid casing part unless the second end (9) of the toroidal magnetic circuit is engaged in the assembly member (5) to the depth required to be in the position overlapping the first end (8) of the toroidal magnetic circuit and therefore in the assembly position.

2. Transformer according to claim 1 characterised in that the assembly member (5) includes guide means (17) projecting from the rigid casing part (19, 20) to guide the second end (9) of the toroidal magnetic circuit on engagement of the latter in the assembly member disposed in its housing (4) in the rigid casing part.

3. Transformer according to either of the preceding claims characterised in that the deformable casing part (21, 22) is in one piece with the rigid casing part (19, 20).

4. Transformer according to any one of the preceding claims characterised in that the deformable casing part (21, 22) has a corrugated structure (26, 28) over part at least of its length.

5. Transformer according to claim 4 characterised in that the deformable casing part comprises in the lengthwise direction an alternation of rigid segments (25, 27) and corrugated segments (26, 28), the corrugated segments preferably having thinner walls than the rigid segments.

6. Transformer according to any one of the preceding claims characterised in that the rigid casing part comprises a back (19) enclosing on three sides the coil (4) and the assembly member (5) introduced into the back via the open fourth side and a lid (20) adapted to close the fourth side.

7. Transformer according to claim 6 characterised in that the lid 20 is moulded in one piece with the back (19) of the rigid casing part and is articulated to the back by a moulded-in hinge (32).

8. Transformer according to any one of the preceding claims characterised in that the deformable casing part comprises a back (21) surrounding the toroidal magnetic circuit (3) on three sides (one edge and the two opposite larger sides) and a lid (22) enclosing the other edge of the toroidal magnetic circuit.

9. Transformer according to any one of claims 6 to 8 characterised in that the back (19, 21) and the lid (20, 22) include snap-fastener means (29, 30, 37, 39, 39, 40) for holding the lid closed on the back.

10. Transformer according to any one of the preceding claims characterised in that the rigid casing part includes means preferably in one piece with the back (19) of this part to press the transformer onto the cable, for example onto a cylindrical segment shape bearing surface (42), and at least one binding member (43), an elastic tie, for example.
